(19) Europäisches Patentamt

European Patent Office

Office européen des brevets

(11) **EP 0 811 170 B1**

(12) **EUROPÄISCHE PATENTSCHRIFT**

(45) Veröffentlichungstag und Bekanntmachung des Hinweises auf die Patenterteilung:
**28.04.1999 Patentblatt 1999/17**

(21) Anmeldenummer: **96902221.9**

(22) Anmeldetag: **09.02.1996**

(51) Int Cl.[6]: **G01R 33/032**, G01R 15/24

(86) Internationale Anmeldenummer:
**PCT/DE96/00208**

(87) Internationale Veröffentlichungsnummer:
**WO 96/26452 (29.08.1996 Gazette 1996/39)**

(54) **VERFAHREN UND ANORDNUNG ZUM MESSEN EINES MAGNETFELDES UNTER AUSNUTZUNG DES FARADAY-EFFEKTS MIT KOMPENSATION VON INTENSITÄTSÄNDERUNGEN**

PROCESS AND DEVICE FOR MEASURING A MAGNETIC FIELD BY FARADAY EFFECT WHILE COMPENSATING FOR INTENSITY VARIATIONS

PROCEDE ET DISPOSITIF DE MESURE DE CHAMPS MAGNETIQUES PAR EFFET DE FARADAY AVEC COMPENSATION DE VARIATIONS D'INTENSITE

(84) Benannte Vertragsstaaten:
**AT BE CH DE FR GB IT LI SE**

(30) Priorität: **22.02.1995 DE 19506169**

(43) Veröffentlichungstag der Anmeldung:
**10.12.1997 Patentblatt 1997/50**

(73) Patentinhaber: **SIEMENS AKTIENGESELLSCHAFT**
**80333 München (DE)**

(72) Erfinder:
• **BOSSELMANN, Thomas**
**D-91054 Erlangen (DE)**
• **MENKE, Peter**
**D-91054 Erlangen (DE)**

(56) Entgegenhaltungen:
**WO-A-92/13280**          **US-A- 5 434 501**

• **OPTICS LETTERS 15 September 1993, XP000396937 MARRONE M J ET AL 'FIBER-OPTIC MAGNETIC FIELD SENSOR WITH AN ORTHOCONJUGATING LOOP MIRROR'**
• **PATENT ABSTRACTS OF JAPAN vol. 009, no. 304 (P-409), 30.November 1985 & JP,A,60 138480 (HITACHI DENSEN KK) 23.Juli 1985**

**Beschreibung**

Die Erfindung betrifft ein Verfahren und eine Anordnung zum Messen eines Magnetfeldes.

Es sind optische Meßanordnungen und Meßverfahren zum Messen eines Magnetfeldes unter Ausnützung des magnetooptischen Faraday-Effekts bekannt. Unter dem Faraday-Effekt versteht man die Drehung der Polarisationsebene von linear polarisiertem Licht in Abhängigkeit von einem Magnetfeld. Der Drehwinkel ist proportional zum Wegintegral über das Magnetfeld entlang des von dem Licht zurückgelegten Weges mit der sogenannten Verdet-Konstanten als Proportionalitätskonstante. Die Verdet-Konstante ist im allgemeinen material-, temperatur-und wellenlängenabhängig. Zum Messen des Magnetfeldes wird eine Faraday-Sensoreinrichtung aus einem optisch transparenten Material wie beispielsweise Glas in dem Magnetfeld angeordnet. Das Magnetfeld bewirkt eine Drehung der Polarisationsebene von durch die Faraday-Sensoreinrichtung gesendetem linear polarisiertem Licht um einen Drehwinkel, die für ein Meßsignal ausgewertet werden kann. Eine bekannte Anwendung finden solche magnetooptischen Meßverfahren und Meßanordnungen beim Messen elektrischer Ströme. Die Faraday-Sensoreinrichtung wird dazu in der Nahe eines Stromleiters angeordnet und erfaßt das von einem Strom in dem Stromleiter erzeugte Magnetfeld. Im allgemeinen umgibt die Faraday-Sensoreinrichtung den Stromleiter, so daß das Meßlicht den Stromleiter in einem geschlossenen Weg umläuft. Der Betrag des Drehwinkels ist in diesem Fall in guter Näherung direkt proportional zur Amplitude des zu messenden Stromes. Die Faraday-Sensoreinrichtung kann als massiver Glasring um den Stromleiter ausgebildet sein oder auch den Stromleiter in Form einer Meßwicklung aus einer lichtleitenden Faser (Faserspule) mit wenigstens einer Windung umgeben.

Vorteile dieser magnetooptischen Meßanordnungen und Meßverfahren gegenüber herkömmlichen induktiven Stromwandlern sind die Potentialtrennung und die Unempfindlichkeit gegenüber elektromagnetischen Störungen. Probleme bereiten bei dem Einsatz von magnetooptischen Stromwandlern jedoch Einflüsse von mechanischen Vibrationen auf die Sensoreinrichtung und die optischen Zuleitungen, die zu die Messung verfälschenden Intensitätsänderungen führen können, und Einflüsse von Temperaturänderungen insbesondere in der Sensoreinrichtung.

Um Vibrationseinflüsse auf die Messung zu reduzieren, ist bekannt, zwei gegenläufige, d.h. in entgegengesetzten Richtungen sich ausbreitende, Lichtsignale durch eine Faraday-Sensoreinrichtung zu senden. Dieser bekannten Maßnahme liegt der Gedanke zugrunde, daß die von den beiden Lichtsignalen auf ihrem gemeinsamen Lichtweg erfahrene lineare Doppelbrechung infolge von Vibrationen als reziproker Effekt von dem nicht-reziproken Faraday-Effekt durch geeignete Signalverarbeitung unterschieden werden kann.

In einer dieser bekannten Ausführungsformen werden zwei gegenläufige, linear polarisierte Lichtsignale durch eine optische Faserspule als Faraday-Sensoreinrichtung gesendet, die einen Stromleiter umgibt. Als optische Faser für die Faserspule ist eine mechanisch tordierte Faser (Twisted fibre) oder eine während des Ziehprozesses tordierte Faser mit einer hohen linearen Doppelbrechung (Spun-HiBi-fibre) vorgesehen. Die optische Faser weist neben dem Faraday-Effekt auch eine im Vergleich zum Faraday-Effekt hohe zirkuläre Doppelbrechung auf. Nach Durchlaufen der Sensoreinrichtung wird jedes der beiden Lichtsignale von einem polarisierenden Strahlteiler in zwei senkrecht zueinander polarisierte Anteile zerlegt. Mit den insgesamt vier Lichtanteilen wird von einer Signalverarbeitung ein Meßsignal für einen elektrischen Strom in dem Stromleiter abgeleitet, das im wesentlichen dem Quotienten aus dem Faraday-Meßwinkel und der zirkularen Doppelbrechung der Faser entspricht und damit unabhängig von einer linearen Doppelbrechung in der optischen Faser ist. Das so erhaltene Meßsignal ist damit zwar weitgehend frei von temperaturinduzierter linearer Doppelbrechung in der Sensoreinrichtung, jedoch ist das Meßsignal wegen der Temperaturabhängigkeit der zirkularen Doppelbrechung der Faser noch temperaturabhängig. Die beiden gegenläufigen Lichtsignale durchlaufen in dieser bekannten Ausführungsform nur die Faraday-Sensoreinrichtung auf einem gemeinsamen Lichtweg und werden beim Austritt aus der Faraday-Sensoreinrichtung wieder durch optische Koppler voneinander getrennt (*WO 92/13280*).

In vier weiteren bekannten Ausführungsformen durchlaufen zwei Lichtsignale eine optische Reihenschaltung aus einer ersten Lichtleitfaser, einem ersten Polarisator, einer Faraday-Sensoreinrichtung, einem zweiten Polarisator und einer zweiten Lichtleitfaser in zueinander entgegengesetztem Umlaufsinn. Beide Lichtsignale werden nach Durchlaufen der optischen Reihenschaltung von entsprechenden photoelektrischen Wandlern in jeweils ein elektrisches Intensitätssignal umgewandelt.

Bei der ersten, aus der *US 4,916,387* bekannten Ausführungsform ist als Faraday-Sensoreinrichtung ein massiver Glasring vorgesehen, der den Stromleiter umgibt. Die Polarisationsachsen der beiden Polarisatoren sind um einen Winkel von 45° zueinander gedreht. Zur Kompensation von unerwünschten Intensitätsänderungen in den optischen Zuleitfasern wird bei diesem aus *US 4,916,387* bekannten Meßsystem davon ausgegangen, daß sich die unerwünschten Intensitätsänderungen (noise) und die Intensitätsänderungen aufgrund des Faraday-Effekts additiv überlagern mit unterschiedlichen Vorzeichen in den beiden elektrischen Intensitätssignalen und damit voneinander getrennt werden können.

Bei der zweiten, aus *Journal of Lightwave Technology, Vol.12. No. 10, October 1994, Seiten 1882 bis 1890* bekannten Ausführungsform ist eine Faserspule aus einer Single-Mode-Faser mit einer niedrigen Doppelbrechung als Faraday-Sensoreinrichtung vorgesehen. Die Polarisationsachsen der beiden Polarisatoren schließen einen von 0° verschiedenen Polarisatorwinkel miteinander ein, der vorzugsweise 45° beträgt. Licht einer einzigen Lichtquelle wird in die zwei Lichtsignale aufgeteilt, und diese Lichtsignale werden jeweils über einen optischen Koppler in die zugeordnete Lichtleitfaser eingekoppelt. Aus den beiden elektrischen Intensitätssignalen, die den Lichtintensitäten der zugeordneten Lichtsignale nach Durchlaufen der Reihenschaltung entsprechen, wird ein Meßsignal abgeleitet, das dem Quotienten aus der Differenz und der Summe der beiden Intensitätssignale entspricht. Damit können die Dämpfungsfaktoren der beiden Lichtleitfasern im wesentlichen kompensiert werden. Die Lichtintensitäten der beiden Lichtsignale beim Einkoppeln in die Reihenschaltung müssen allerdings genau gleich eingestellt werden.

Bei der dritten, aus *H.Sohlström et al, "Transmission loss compensation for Faraday effect fibre optic sensors", Conference Eurosensors VIII, Toulouse, 25.-28.9.1994* bekannten Ausführungsform einer magnetooptischen Meßanordnung ist die optische Reihenschaltung aus Multimode-Fasern als Lichtleitfasern, Polarisatoren und Faraday-Sensoreinrichtung zwischen zwei Infrarot-Leuchtdioden geschaltet. Die beiden Leuchtdioden werden abwechselnd als Lichtquelle und als Photodetektor betrieben. Es durchläuft somit zu einem Zeitpunkt immer nur eines der beiden gegenläufigen Lichtsignale die Reihenschaltung. Die Umschalttaktfrequenz wird deshalb möglichst hoch gewählt.

Bei der vierten, aus der *JP-A-60 138 480* sowie dem zugehörigen Abstract *(Patent Abstracts of Japan, Bd. 9, Nr. 304 (P-409), 30.11.85)* bekannten Ausführungsform sind die Polarisationsachsen der beiden Polarisatoren vorzugsweise um einen Winkel von 45° zueinander gedreht. Licht einer einzigen Lichtquelle (LED) wird über einen halbdurchlässigen optischen Spiegel in zwei exakt gleich große Lichtsignale aufgeteilt. Diese gleich großen Lichtsignale werden jeweils über einen weiteren halbdurchlässigen optischen Spiegel mit entgegengesetzter Laufrichtung in die optische Reihenschaltung eingekoppelt. Der offenbarte optische Wandler dient dabei insbesondere der hoch genauen Detektion von DC-Magnetfeldern bzw. von DC-haltigen Magnetfeldern.

In einer weiteren, aus *"Optics Letters", Bd. 18, Nr. 18, 15.09.93, Seiten 1556 bis 1558* bekannten Ausführungsform durchlaufen zwei Lichtsignale eine optische Reihenschaltung aus einer ersten Lichtleitfaser, einem Faraday-Rotator, der die Polarisationsebene um einen von Magnetfeld unabhängigen Drehwinkel von 45° dreht, einer Faraday-Sensoreinrichtung und einer zweiten Lichtleitfaser in zueinander entgegengesetztem Umlaufsinn. Hierbei ist dieser Faraday-Rotator ein für die Wirkungsweise des Verfahrens bzw. der Anordnung notwendiger Bestandteil als Polarisationskoppler, der das in der Meßschleife zirkulierende Meßlicht jeweils aus der einen Eigenmode der polarisationserhaltenden Faser der Meßschleife in die dazu senkrecht angeordnete zweite Eigenmode der Faser überkoppelt.

Der Erfindung liegt nun die Aufgabe zugrunde, ein Meßverfahren und eine Meßanordnung zum Messen eines Magnetfeldes und insbesondere zum Messen eines elektrischen Stromes unter Ausnutzung des Faraday-Effekts anzugeben, bei denen Intensitätsänderungen in den optischen Übertragungsstrecken für zwei gegenläufige Lichtsignale praktisch vollständig eliminiert sind.

Diese Aufgabe wird gemäß der Erfindung gelöst mit den Merkmalen des Anspruchs 1 bzw. des Anspruchs 9. Zwei Lichtsignale durchlaufen eine optische Reihenschaltung aus einer ersten optischen Übertragungsstrecke, einem ersten Polarisator, einer Faraday-Sensoreinrichtung, einem zweiten Polarisator und einer zweiten optischen Übertragungsstrecke in zueinander entgegengesetzten Durchlaufrichtungen. Zwischen den beiden Polarisatoren wird die Polarisationsebene jedes der beiden Lichtsignale um einen vorgegebenen, vom Magnetfeld unabhängigen Drehwinkel $\alpha$ gedreht. Durch die Wahl dieses Drehwinkels $\alpha$ kann der Arbeitspunkt des Meßverfahrens oder der Meßanordnung bei Magnetfeld Null eingestellt werden. Zum Drehen der Polarisationsebenen beider Lichtsignale um den vorgegebenen Drehwinkel $\alpha$ sind optisch zwischen die beiden Polarisatoren geschaltete Rotationsmittel vorgesehen. Mit den Lichtintensitäten der beiden Lichtsignale jeweils nach deren Durchlaufen der optischen Reihenschaltung wird ein von Intensitätsänderungen in den beiden Übertragungsstrecken im wesentlichen unabhängiges Meßsignal für das Magnetfeld hergeleitet. Zum Herleiten des Meßsignals sind entsprechende Auswertemittel vorgesehen.

Vorteilhafte Ausgestaltungen und Weiterbildungen des Verfahrens und der Anordnung gemäß der Erfindung ergeben sich aus den jeweils abhängigen Ansprüchen.

In einer ersten vorteilhaften Ausführungsform wird der vorgegebene Drehwinkel $\alpha$ auf ein ungeradzahliges Vielfaches von etwa $\pm$ 45° oder $\pm$ $\pi/4$ eingestellt. Damit wird der Arbeitspunkt des Meßverfahrens und der Meßanordnung so eingestellt, daß die Meßempfindlichkeit maximal ist.

Die Rotationsmittel können mit einem oder mehreren Rotationselementen gebildet sein, die jeweils eine reziproke zirkuläre Doppelbrechung aufweisen. Eine solche reziproke Rotation der Polarisationsebenen der beiden Lichtsignale kann mit Hilfe optisch aktiver Materialien oder auch mit Hilfe einer geometrisch induzierten zirkularen Doppelbrechung erzielt werden. In einer besonderen Ausführungsform bildet die Faraday-Sensoreinrichtung selbst wenigstens einen Teil der Rotationsmittel und weist dazu neben dem Faraday-Effekt auch eine reziproke zirkuläre Doppelbrechung auf.

Die Polarisationsachsen der beiden Polarisatoren werden vorzugsweise wenigstens annähernd parallel zueinander oder wenigstens annähernd orthogonal zueinander eingestellt.

Die beiden optischen Übertragungsstrecken für die Lichtsignale können mit Multimode-Lichtleitern gebildet sein.

Als Meßsignal wird vorzugsweise ein Quotient zweier linearer Funktionen der Licht intensitäten der beiden Lichtsignale ermittelt. Die Koeffizienten dieser linearen Funktionen können unterschiedlichen Eingangsintensitäten der beiden Lichtsignale beim Einkoppeln in die Reihenschaltung angepaßt werden. Insbesondere bei gleichen Eingangsintensitäten beider Lichtsignale kann das Meßsignal proportional zum Quotienten aus einer Differenz und der Summe beider Lichtintensitäten gewählt werden. Außerdem kann auch ein zu einem Quotienten der beiden Lichtintensitäten der beiden Lichtsignale proportionales Meßsignal verwendet werden.

Wenn die Faraday-Sensoreinrichtung eine lineare Doppelbrechung zeigt, können Temperaturänderungen zu Meßfehlern führen. In einer vorteilhaften Ausführungsform werden zur Kompensation dieser Temperatureinflüsse die Polarisationsachsen der beiden Polarisatoren um einen vorgegebenen Polarisatorwinkel $\gamma$ gegen eine Eigenachse der linearen Doppelbrechung in der Sensoreinrichtung gedreht, wobei dieser Polarisatorwinkel $\gamma$ wenigstens annähernd durch $\cos(4\gamma-2\alpha) = -2/3$ bestimmt ist.

Zur weiteren Erläuterung der Erfindung wird auf die Zeichnung Bezug genommen, in deren

FIG 1 ein prinzipieller Aufbau der Meßanordnung zum Messen eines Magnetfeldes mit einer Faraday-Sensoreinrichtung und Rotationsmitteln,

FIG 2 eine Meßanordnung zum Messen eines elektrischen Stromes mit einer Faraday-Sensoreinrichtung und Rotationsmitteln

FIG 3 ein Zeigerdiagramm der Polarisationsdrehung der beiden gegenläufigen Lichtsignale bei um einen Winkel von 45° gegeneinander geneigten Polarisationsachsen der Polarisatoren gemäß dem Stand der Technik und

FIG 4 ein Zeigerdiagramm der Polarisationsdrehung der beiden gegenläufigen Lichtsignale bei parallelen Polarisationsachsen der beiden Polarisatoren und einem vorgegebenen Drehwinkel $\alpha = 45°$

jeweils schematisch dargestellt sind. Einander entsprechende Teile sind mit denselben Bezugszeichen versehen.

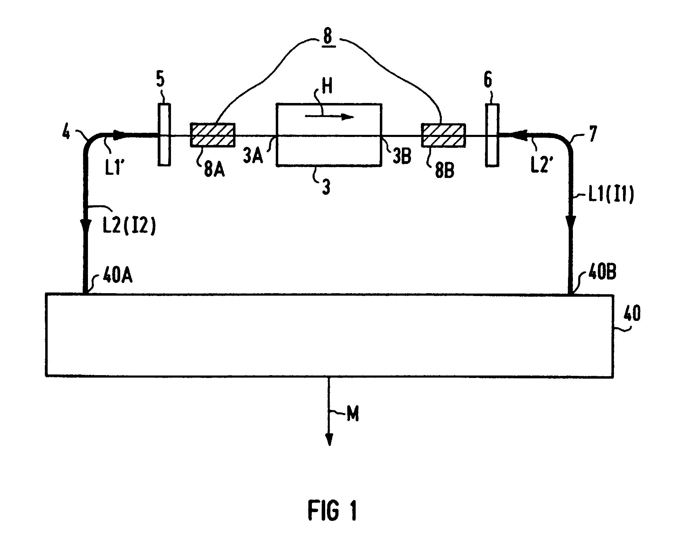

In der FIG 1 sind eine Faraday-Sensoreinrichtung mit 3, zwei optische Übertragungsstrecken mit 4 und 7 zwei Polarisatoren mit 5 und 6, optische Rotationsmittel mit 8 und eine Sende-und Auswerteeinheit mit 40 bezeichnet.

Die Faraday-Sensoreinrichtung 3 besteht aus wenigstens einem den magnetooptischen Faraday-Effekt zeigenden Material. Unter dem Einfluß eines die Sensoreinrichtung 3 wenigstens teilweise durchdringenden Magnetfeldes **H** wird die Polarisation von durch die Sensoreinrichtung 3 laufendem polarisierten Licht aufgrund des Faraday-Effekts geändert. Die Sensoreinrichtung 3 kann in an sich bekannter Weise mit einem oder mehreren massiven Körpern, vorzugsweise aus Glas, oder auch mit mindestens einer optischen Faser ausgebildet sein. Die Sensoreinrichtung 3 weist zwei optische Anschlüsse 3A und 3B derart auf, daß an einem Anschluß 3A oder 3B eingekoppeltes Licht die Sensoreinrichtung 3 durchläuft und am jeweils anderen Anschluß 3B bzw. 3A wieder ausgekoppelt wird. Der erste Anschluß 3A der Sensoreinrichtung 3 ist über den ersten Polarisator 5 mit einem Ende der ersten optischen Übertragungsstrecke 4 optisch gekoppelt. Der zweite Anschluß 3B der Sensoreinrichtung 3 ist über den zweiten Polarisator 6 mit einem Ende der zweiten optischen Übertragungsstrecke 7 optisch gekoppelt.

Zwischen die beiden Polarisatoren 5 und 6 sind die optischen Rotationsmittel 8 optisch geschaltet. Die Rotationsmittel 8 drehen die Polarisationsebene von sie durchlaufendem linear polarisiertem Licht reziprok um einen vorgegebenen Drehwinkel $\alpha$. Die Rotationsmittel 8 enthalten im allgemeinen wenigstens ein Rotationselement, das eine reziproke zirkuläre Doppelbrechung aufweist.

In der dargestellten Ausführungsform umfassen die Rotationsmittel 8 zwei Rotationselemente 8A und 8B. Das erste Rotationselement 8A ist zwischen den ersten Polarisator 5 und den ersten Anschluß 3A der Sensoreinrichtung 3 optisch geschaltet, und das zweite Rotationselement 8B ist zwischen den zweiten Anschluß 3B der Sensoreinrichtung 3 und den zweiten Polarisator 6 optisch geschaltet. Der Drehwinkel $\alpha$ der Rotationsmittel 8 ergibt sich in dieser Ausführungsform als Summe der einzelnen Drehwinkel der beiden Rotationselemente 8A und 8B. Beispielsweise kann jedes Rotationselement 8A und 8B eine Drehung der Polarisationsebenen beider Lichtsignale L1' und L2' um $\alpha/2$ bewirken.

Die Rotationsmittel 8 können aber auch nur zwischen dem ersten Polarisator 5 und dem ersten Anschluß 3A der Sensoreinrichtung 3 oder nur zwischen dem zweiten Polarisator 6 und dem zweiten Anschluß 3B der Sensoreinrichtung 3 angeordnet sein.

Die Rotationsmittel 8 bzw. ihre Rotationselemente 8A und 8B sind vorzugsweise mit optisch aktiven Materialien gebildet. Die optische Aktivität bewirkt eine reziproke Drehung der Polarisationsebene von durchlaufendem linear polarisiertem Licht und ist damit ein Spezialfall von reziproker zirkularer Doppelberechung.

Außerdem können die Rotationsmittel 8 bzw. die Rotationselemente 8A und 8B auch mit Hilfe von optischen Elementen realisiert werden, die eine geometrisch induzierte reziproke zirkuläre Doppelbrechung aufweisen. Eine reziproke Drehung der Polarisationsebene wird in diesen Fällen durch die geometrisch-körperliche Ausbildung der Rotationsmittel 8 bzw. Rotationselemente 8A und 8B erreicht. Beispiele sind mit Hilfe eines Drehmoments tordierte optische Fasern (Twisted Fibre) oder auch helixförmig gewickelte optische Fasern.

In einer besonderen Ausführungsform weist die Sensoreinrichtung 3 selbst eine wohldefinierte reziproke zirkuläre Doppelbrechung auf und bildet damit zumindest einen Teil der Rotationsmittel 8.

Die Polarisationsachsen (polarization axis, transmission axis) der beiden Polarisatoren 5 und 6 sind vorzugsweise wenigstens annähernd parallel oder wenigstens annähernd senkrecht zueinander eingestellt. Der Arbeitspunkt der Anordnung für $H = 0$ wird dann ausschließlich über den Drehwinkel $\alpha$ der Rotationsmittel 8 eingestellt.

Die optische Reihenschaltung aus erster optischer Übertragungsstrecke 4, erstem Polarisator 5, Sensoreinrichtung 3, zweitem Polarisator 6 und zweiter optischer Übertragungsstrecke 7 sowie die Rotationsmittel 8 sind optisch zwischen zwei Anschlüsse 40A und 40B der Sende- und Auswerteeinheit 40 geschaltet. Die Sende- und Auswerteeinheit 40 enthält Mittel zum Senden von zwei gegenläufigen Lichtsignalen L1' und L2' durch die optische Reihenschaltung und die Rotationsmittel 8 sowie Auswertemittel zum Auswerten der beiden Lichtintensitäten der mit L1 und L2 bezeichneten Lichtsignale nach Durchlaufen der Reihenschaltung für ein Meßsignal M für das Magnetfeld $H$, das von Intensitätsänderungen in den beiden Übertragungsstrecken 4 und 7 praktisch unabhängig ist. Das Meßsignal M ist an einem Ausgang der Sende- und Auswerteinheit 40 abgreifbar.

Das erste Lichtsignal L1' wird an dem Anschluß 40A der Sende-und Auswerteeinheit 40 in die erste Übertragungsstrecke 4 eingekoppelt und nach Durchlaufen der ersten Übertragungsstrecke 4 von dem ersten Polarisator 5 linear polarisiert. Das nunmehr linear polarisierte Lichtsignal L1' wird anschließend am Anschluß 3A in die Sensoreinrichtung 3 eingespeist. Beim Durchlaufen der Sensoreinrichtung 3 wird die Polarisationsebene des linear polarisierten ersten Lichtsignals L1' um einen vom Magnetfeld $H$ abhängigen Faraday-Meßwinkel $\rho$ gedreht. Von den Rotationsmitteln 8 wird das linear polarisierte erste Lichtsignal L1' ferner um den vorgegebenen, vom Magnetfeld $H$ unabhängigen Drehwinkel $\alpha$ gedreht. Die Polarisationsebene des ersten Lichtsignals L1' wird somit zwischen den beiden Polarisatoren 5 und 6 um einen Gesamtdrehwinkel $\rho+\alpha$ gedreht, der der Summe aus dem Meßwinkel $\rho$ und dem festen Drehwinkel $\alpha$ entspricht. Ein positiver Winkelwert entspricht dabei und im folgenden dem mathematisch positiven Drehsinn, also dem Gegenuhrzeigersinn, ein negativer Winkelwert dagegen dem mathematisch negativen Drehsinn, d.h. dem Uhrzeigersinn, bezogen auf die Ausbreitungsrichtung des betrachteten Lichtsignals.

Das in seiner Polarisationsebene um den Gesamtdrehwinkel $\rho+\alpha$ gedrehte erste Lichtsignal L1' wird nun dem zweiten Polarisator 6 zugeführt. Der zweite Polarisator 6 läßt nur den auf seine Polarisationsachse projizierten Anteil des ankommenden ersten Lichtsignals L1' durch und hat somit für das erste Lichtsignal L1' die Funktion eines Polarisationsanalysators. Der vom zweiten Polarisator 6 transmittierte Anteil des ersten Lichtsignals L1' ist mit L1 bezeichnet und wird über die zweite Übertragungsstrecke 7 zum zweiten Anschluß 40B der Sende- und Auswerteeinheit 40 übertragen.

Das zweite Lichtsignal L2' wird am Anschluß 40B der Sende-und Auswerteeinheit 40 in die zweite Übertragungsstrecke 7 eingekoppelt und nach Durchlaufen der zweiten Übertragungsstrecke 7 von dem ersten Polarisator 5 linear polarisiert. Das linear polarisierte zweite Lichtsignal L2' wird von den Rotationsmitteln 8 um den vorgegebenen, vom Magnetfeld $H$ unabhängigen Drehwinkel $\alpha$ gedreht, der im Bezugssystem des zweiten Lichtsignals L2' das gleiche Vorzeichen und den gleichen Betrag wie beim ersten Lichtsignal L1' hat. Das um den Drehwinkel $\alpha$ in seiner Polarisationsebene gedrehte, linear polarisierte zweite Lichtsignal L2' wird nun am Anschluß 3B in die Sensoreinrichtung 3 eingekoppelt. Beim Durchlaufen der Sensoreinrichtung 3 wird die Polarisationsebene des linear polarisierten zweiten Lichtsignals L2' um einen vom Magnetfeld $H$ abhängigen Faraday-Meßwinkel $-\rho$ gedreht, der wegen der nicht-reziproken Eigenschaft des Faraday-Effekts den gleichen Betrag, aber das entgegengesetzte Vorzeichen aufweist wie beim ersten Lichtsignal L1'. Die Polarisationsebene des ersten Lichtsignals L1' wird somit zwischen den beiden Polarisatoren 6 um einen Gesamtdrehwinkel $\alpha-\rho$ gedreht, der der Summe aus dem festen Drehwinkel $\alpha$ und dem Meßwinkel $-\rho$ und entspricht. Das in seiner Polarisationsebene um den Gesamtdrehwinkel $\alpha-\rho$ gedrehte zweite Lichtsignal L2' wird nun dem zweiten Polarisator 6 zugeführt. Der zweite Polarisator 6 läßt nur den auf seine Polarisationsachse projizierten Anteil des ankommenden zweiten Lichtsignals L2' durch und wirkt somit für das zweite Lichtsignal L2' als Polarisationsanalysator. Der vom zweiten Polarisator 6 transmittierte Anteil des zweiten Lichtsignals L2' ist mit L2 bezeichnet und wird über die erste Übertragungsstrecke 4 zum ersten Anschluß 40A der Sende- und Auswerteeinheit 40 übertragen.

Die nicht dargestellten Auswertemittel in der Sende- und Auswerteeinheit 40 leiten aus den Lichtintensitaten I1 und I2 der beiden Lichtsignale L1 und L2 nach Durchlaufen der Reihenschaltung ein Meßsignal M für das Magnetfeld $H$ ab, das von Intensitätsänderungen in den beiden Übertragungsstrecken 4 und 7 weitgehend unabhängig ist.

Da Lichtintensitätsschwankungen im Meßsignal M im wesentlichen kompensiert sind, können auch einfache Multimode-Fasern als Übertragungsstrecken 4 und 7 verwendet werden.

Die Sende- und Auswerteeinheit 40 kann beispielsweise nicht dargestellte, abwechselnd als Sender und Detektor betriebene Leuchtdioden enthalten, die mit entsprechenden Stromquellen und Auswerteelektroniken elektrisch verbunden sind. Weitere Ausführungsformen der Mittel zum Senden der beiden Lichtsignale Ll'und L2' und der Auswertemittel zum Auswerten der Lichtintensitaten I1 und I2 der beiden Lichtsignale L1 und L2 nach Durchlaufen der Reihenschaltung werden im folgenden noch beschrieben.

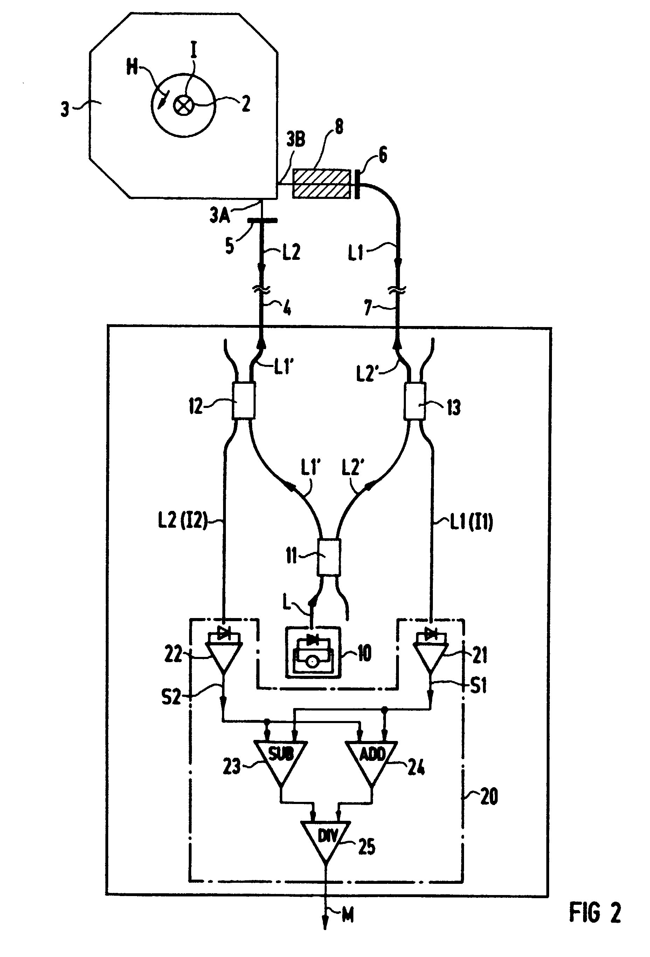

FIG 2 zeigt eine vorteilhafte Ausführungsform der Meßanordnung. Das von der Sensoreinrichtung 3 abgewandte Ende der ersten Übertragungsstrecke 4 ist über einen optischen Koppler 12 sowohl mit einem weiteren optischen Koppler 11 als auch mit Auswertemitteln 20 optisch verbunden. Das von der Sensoreinrichtung 3 abgewandte Ende der zweiten Übertragungsstrecke 4 ist über einen dritten optischen Koppler 13 ebenfalls sowohl mit dem optischen Koppler 11 als auch mit den Auswertemitteln 20 optisch verbunden. Der optische Koppler 11 ist mit einer Lichtquelle 10 optisch verbunden und teilt das Licht L der Lichtquelle 10 in zwei Lichtsignale L1' und L2' auf, die den Kopplern 12 bzw. 13 zugeführt werden und dann in die erste bzw. zweite Übertragungsstrecke 4 bzw. 7 eingekoppelt werden. Beide Lichtsignale L1' und L2' durchlaufen die optische Reihenschaltung aus erster Übertragungsstrecke 4, erstem Polarisator 5, Sensoreinrichtung 3, zweitem Polarisator 6 und zweiter Übertragungsstrecke 7 in zueinander entgegengesetzten Durchlaufrichtungen und werden als nun mit L1 bzw. L2 bezeichnete Lichtsignale wieder aus der Reihenschaltung ausgekoppelt. Die Lichtquelle 10 und die drei optischen Koppler 11, 12 und 13 bilden somit Mittel zum Senden von zwei gegensinnig die Reihenschaltung durchlaufenden Lichtsignalen L1 und L2 durch die Reihenschaltung.

Die Koppler 11, 12 und 13 können wenigstens teilweise auch durch optische Strahlteiler ersetzt werden. Außerdem können anstelle des Kopplers 11 und der einen Lichtquelle 10 auch zwei Lichtquellen vorgesehen sein, die jeweils ein Lichtsignal L1' bzw. L2' senden.

Die Lichtintensitäten I1. und I2' der beiden Lichtsignale L1' und L2' vor dem Einkoppeln in die Reihenschaltung werden im allgemeinen in einem fest vorgegebenen Verhältnis zueinander eingestellt. Vorzugsweise sind beide Lichtintensitäten gleich, also I1' = I2'. In den dargestellten Ausführungsformen teilt der Koppler 11 das Licht L der Lichtquelle 10 dann in zwei gleiche Teile mit einem Kopplungsverhältnis 50%:50%.

Die Meßanordnung gemäß FIG. 2 ist vorzugsweise zum Messen eines elektrischen Stromes I in wenigstens einem Stromleiter 2 vorgesehen. Die Faraday-Sensoreinrichtung 3 erfaßt das von diesem Strom I induktiv erzeugte Magnetfeld **H** und dreht die Polarisationsebenen der beiden Lichtsignale L1' und L2' um einen vom Magnetfeld **H** und damit vom Strom I abhängigen Meßwinkel ρ bzw. -ρ. In der dargestellten, besonders vorteilhaften Ausführungsform umgibt die Sensoreinrichtung 3 den Stromleiter 2, so daß beide Lichtsignale L1' und L2' den Strom I in einem praktisch geschlossenen Lichtpfad umlaufen. Der Meßwinkel ρ ist in diesem Fall direkt proportional zum elektrischen Strom I. Die Sensoreinrichtung 3 kann als massiver Glasring mit die Lichtsignale L1' und L2' umlenkenden inneren Reflexionsflächen oder auf irgendeine andere bekannte Art und Weise ausgebildet sein.

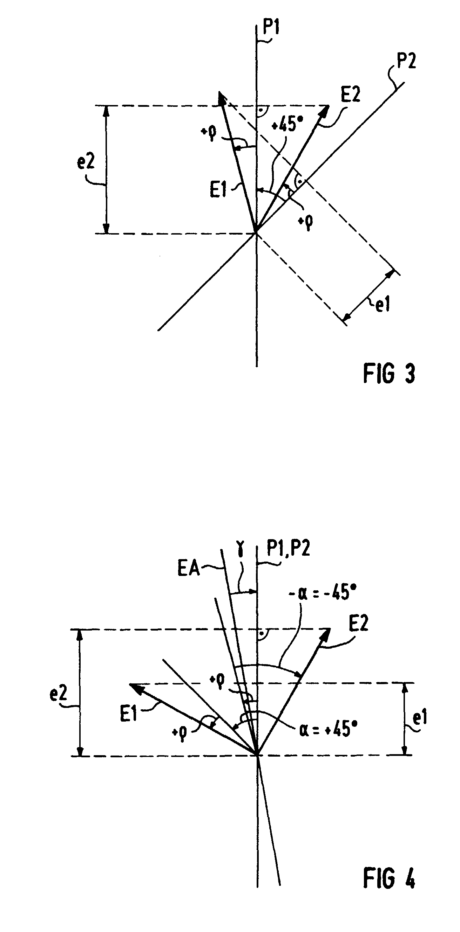

Das Funktionsprinzip des Meßverfahrens und der Meßanordnung im Vergleich zu aus dem Stand der Technik bekannten Verfahren bzw. Anordnungen wird nun anhand der Zeigerdiagramme der FIG. 3 und 4 näher erläutert.

In FIG. 3 ist ein Zeigerdiagramm für die elektrischen Feldvektoren **E1** und **E2** der beiden gegenläufigen Lichtsignale L1' bzw. L1 und L1' bzw. L2 dargestellt, das sich ergibt, wenn man eine Meßanordnung gemäß FIG. 1 ohne Rotationsmittel 8 und mit zueinander um einen Polarisatorwinkel von 45° gedrehten Polarisationsachsen der beiden Polarisatoren 5 und 6 betreibt. Die Polarisationachse des ersten Polarisators 5 ist mit P1 und die Polarisationsachse des zweiten Polarisators 6 mit P2 bezeichnet. Die beiden Polarisationsachsen P1 und P2 sind um den Polarisatorwinkel von 45° zueinander geneigt. Der elektrische Feldvektor **E1** des ersten Lichtsignals L1' ist nach dem Durchlaufen des ersten Polarisators 5 parallel zu dessen Polarisationsachse P1 gerichtet und wird dann in der Sensoreinrichtung 3 um den Meßwinkel ρ gedreht, der ohne Beschränkung der Allgemeinheit als positiv angenommen wird. Das um den Meßwinkel ρ in seiner Polarisationsebene gedrehte erste Lichtsignal L1' wird dann direkt - die optischen Rotationsmittel 8 sind nicht vorhanden - dem zweiten Polarisator 6 zugeführt. Der zweite Polarisator 6 läßt nur den auf seine Polarisationsachse P2 projizierten Anteil des elektrische Feldvektors **E1** durch, dessen Feldstärke mit e1 bezeichnet ist. Für den projizierten Anteil e1 gilt

$$e1 = |E1| \cos(45°+ρ) \qquad (1)$$

Die Lichtintensität I1 des vom zweiten Polarisator 6 transmittierten Lichtsignals L1 ist durch

$$I1 = (e1)^2 \sim \cos^2(45°+ρ) \qquad (2)$$

gegeben.

Der elektrische Feldvektor **E2** des zweiten Lichtsignals L2' wird dagegen parallel zur Polarisationsachse P2 des zweiten Polarisators 6 in die Sensoreinrichtung 3 eingekoppelt und unter dem Einfluß des Magnetfeldes **H** um den Meßwinkel +ρ gedreht. Der Meßwinkel +ρ ist wegen der nicht-reziproken Eigenschaft des Faraday-Effekts im durch die Ausbreitungsrichtung des ersten Lichtsignals L1' festgelegten, dargestellten Bezugssystem ebenfalls positiv. Der als Analysator für das zweite Lichtsignal L2' vorgesehene erste Polarisator 5 läßt nur den auf seine Polarisationsachse P1 projizierten Anteil e2 des um den Meßwinkel +ρ gedrehten elektrische Feldvektor **E2** des zweiten Lichtsignals L2' durch. Für diesen projizierten Anteil e2 gilt nun

$$e2 = |E2| \cos(45°\text{-}\rho) \qquad (3).$$

Die Lichtintensität I2 des vom ersten Polarisator 5 durchgelassenen zweiten Lichtsignals L2 ist

$$I2 = (e2)^2 \sim \cos^2(45°\text{-}\rho) \qquad (4).$$

Aus den Beziehungen (2) und (4) kann man erkennen, daß mit einem Polarisatorwinkel von 45° zwischen den beiden Polarisatoren der Arbeitspunkt der Messung bei cos2(45°) und damit bei einer maximalen Meßempfindlichkeit liegt.

Die FIG. 4 zeigt zum Vergleich in einem Zeigerdiagramm die elektrischen Feldvektoren **E1** und **E2** der beiden Lichtsignale L1 und L2 beim Durchlaufen der Reihenschaltung in einem Aufbau gemäß FIG. 1 oder FIG. 2 mit optischen Rotationsmitteln 8 und parallel zueinander eingestellten Polarisationsachsen P1 und P2 der beiden Polarisatoren 5 und 6. Beide elektrische Feldvektoren **E1** und **E2** der beiden Lichtsignale L1' und L2' sind nach Durchlaufen des ersten Polarisators 5 bzw. des zweiten Polarisators 6 also parallel zueinander gerichtet. Der Drehwinkel α der Rotationsmittel 8 ist in der dargestellten vorteilhaften Ausführungsform auf 45° eingestellt. Der elektrische Feldvektor **E1** des ersten Lichtsignals L1' wird zunächst in der Sensoreinrichtung 3 um den Meßwinkel +ρ und dann von den Rotationsmitteln 8 um den Drehwinkel α = +45° gedreht. Die Vorzeichen der betrachteten Winkel sind wie in FIG. 3 bezogen auf das durch die Durchlaufrichtung des ersten Lichtsignals L1' festgelegte Bezugssystem.

Vom als Analysator für das erste Lichtsignal L1' wirkenden zweiten Polarisator 6 wird nur der auf die Polarisationsachse P1 (=P2) projizierte Anteil

$$e1 = |E1| \cos(\rho\text{+}\alpha) = |E1| \cos(\rho\text{+}45°) \qquad (5)$$

durchgelassen. Die Lichtintensität I1 des ersten Lichtsignals L1 nach Durchlaufen des zweiten Polarisators 6 ist somit

$$I1 = (e1)^2 \sim \cos^2(\rho\text{+}\alpha) = \cos^2(\rho\text{+}45°) \qquad (6).$$

Der elektrische Feldvektor **E2** des zweiten Lichtsignals L2' wird aus seiner zur Polarisationsachse P2 (=P1) des zweiten Polarisators 6 parallelen Ausgangslage von den optischen Rotationsmitteln 8 um den Drehwinkel -α = -45° gedreht, dessen Vorzeichen im durch die Durchlaufrichtung des ersten Lichtsignals L1' festgelegten Bezugssystem gewählt ist und durch die reziproke zirkuläre Doppelbrechung in den Rotationsmitteln 8 bestimmt ist. In der Sensoreinrichtung 3 wird der elektrische Feldvektor **E2** des zweiten Lichtsignals L2' durch das Magnetfeld **H** um den Meßwinkel +ρ gedreht. Der erste Polarisator 5 läßt als Analysator für das zweite Lichtsignal L2' den auf die Polarisationsachse P1 projizierten Anteil

$$e2 = |E2| \cos(\rho\text{-}\alpha) = |E2| \cos(\rho\text{-}45°) \qquad (7)$$

durch. Die Lichtintensität I2 des zweiten Lichtsignals L2 nach Durchlaufen des ersten Polarisators 5 ist somit

$$I2 = (e2)^2 \sim \cos^2(\rho\text{-}\alpha) = \cos^2(\rho\text{-}45°) \qquad (8).$$

Die beiden Lichtintensitaten I1 und I2 der beiden Lichtsignale L1 und L2 nach Durchlaufen der Reihenschaltung gemäß den Beziehungen (2) und (6) bzw. (4) und (8) stimmen also im wesentlichen überein. Der Arbeitspunkt des Meßverfahrens oder der Meßanordnung kann somit durch die Verwendung der Rotationsmittel 8 auch bei parallel zueinander gerichteten Polarisationsachsen P1 und P2 der beiden Polarisatoren 5 und 6 in einen Eindeutigkeitsbereich der Kennlinie für Drehwinkel α ≠ 0° und insbesondere in den Punkt maximaler Meßempfindlichkeit für Drehwinkel α = ± 45° eingestellt werden. Dies gilt analog auch bei wenigstens annähernd senkrecht zueinander eingestellten Polarisationsachsen P1 und P2 der Polarisatoren 5 und 6. Der Justageaufwand beim Einstellen des Arbeitspunktes kann somit mit Hilfe der Rotationsmittel 8 verringert werden.

Beim Durchlaufen der beiden Übertragungsstrecken 4 und 7 erfahren beide Lichtsignale L1' bzw. L1 und L2' bzw. L2 jeweils die gleichen Intensitätsänderungen, die insbesondere durch Dämpfungsverluste infolge von mechanischen Vibrationen verursacht werden können. Diese Intensitätsänderungen gehen im wesentlichen in Form von Dampfungsfaktoren in die Lichtintensitäten I1 und I2 ein. Der reelle, im allgemeinen zeitabhängige Dampfungsfaktor einer optischen Übertragungsstrecke ist definiert als das Verhältnis der Lichtintensität von an einem Ende der Übertragungsstrecke ankommendem Licht zu der Eingangslichtintensität des Lichts beim Einkoppeln in das andere Ende der Übertragungsstrecke. Sei A der reelle Dämpfungsfaktor der ersten Übertragungsstrecke 4 und B der Dämpfungsfaktor der zweiten Übertragungsstrecke 7. Dann gelten für die Lichtintensitäten I1 und I2 der beiden Lichtsignale L1 und L2 nach Durchlaufen der optischen Reihenschaltung unter Berücksichtigung der Beziehungen (6) und (8) die allgemeinen Beziehungen:

$$I1 = I0 \cdot A \cdot B \cdot \cos^2(\rho+\alpha) \qquad (9)$$

$$I2 = K \cdot I0 \cdot B \cdot A \cdot \cos^2(\rho-\alpha) \qquad (10).$$

I0 ist eine fest vorgegebene Ausgangsintensität. K ist ein Kopplungsfaktor, der sich in der dargestellten Ausführungsform aus den Kopplungsverhältnissen der Koppler 11, 12 und 13 ergibt. Wenn die Kopplungsverhältnisse aller Koppler 11, 12 und 13 jeweils 50%:50% sind, ist K=1. Die $\cos^2$-Terme in den Gleichungen (9) und (10) beschreiben die Abhängigkeit der Lichtintensität I1 bzw. I2 von dem Faraday-Meßwinkel ρ für einen vorgegebenen Drehwinkel α. Die Faktoren vor den $\cos^2$-Termen in den Ausdrücken für die beiden Lichtintensitäten I1 und I2 gemäß den Gleichungen (9) und (10) unterscheiden sich nur in dem Kopplungsfaktor K.

Die Dampfungsfaktoren A und B der Übertragungsstrecken 4 und 7 werden nun in einer besonders vorteilhaften Ausführungsform eliminiert, indem die Auswertemittel 20 bzw. die Sende- und Auswerteeinheit 40 als Meßsignal M für das Magnetfeld **H** ein Quotientensignal der Gestalt

$$M = (a \cdot I1+b \cdot I2+c)/(d \cdot I1+e \cdot I2+f) \qquad (11)$$

aus zwei linearen Funktionen a·I1+b·I2+c und d·I1+e·I2+f der beiden Lichtintensitäten I1 und I2 mit den reellen Koeffizienten a, b, c, d, e und f ableiten. Dabei sind wenigstens entweder die Koeffizienten a und e oder die Koeffizienten b und d von Null verschieden.

Dieses Meßsignal M gemäß Gleichung (11) ist von insbesondere von Vibrationen verursachten Intensitätsänderungen in den Übertragungsstrecken 4 bzw. 7 praktisch unabhängig. Somit können in allen Ausführungsformen auch einfache, vergleichsweise preiswerte Telekommunikationslichtfasern (Multimode-Fasern) als Übertragungsstrecken 4 und 7 verwendet werden, da deren relativ hohe Dämpfungen und Vibrationsempfindlichkeiten im Meßsignal M kompensiert sind. Als Übertragungsstrecken 4 und 7 können aber auch andere Lichtwellenleiter oder Freistrahlanordnungen verwendet werden.

Die Koeffizienten a, b, c, d, e und f der linearen Funktionen im Zähler und Nenner von Gleichung (11) können insbesondere unterschiedlichen Eingangsintensitäten der beiden Lichtsignale beim Einkoppeln in die Reihenschaltung angepaßt werden. Vorzugsweise werden die Koeffizienten a, b, c, d, e und f für die gemäß den Gleichungen (9) und (10) bestimmten Lichtintensitäten I1 und I2 so angepaßt, daß sich ohne Berücksichtigung von linearen Doppelbrechungseffekten in der Sensoreinrichtung 3 ein Meßsignal

$$M \sim \sin(2\rho) \qquad (12)$$

ergibt, das im wesentlichen proportional zum Sinus des doppelten Faraday-Meßwinkels ρ ist. Die Koeffizienten d, e und f der linearen Funktion d·I1+e·I2+f im Nenner des Quotienten gemäß Gleichung (11) werden vorzugsweise so eingestellt, daß die lineare Funktion d·I1+e·I2+f praktisch konstant und damit unabhängig vom Magnetfeld **H** ist.

In einer besonderen Ausführungsform wird ein Quotient

$$M = I1/I2 = \cos^2(\rho+\alpha) \,/\, (K \cdot \cos^2(\rho-\alpha)) \qquad (13)$$

oder

$$M = I2/I1 = (K \cdot \cos^2(\rho-\alpha)) \,/\, \cos^2(\rho+\alpha) \qquad (13')$$

aus beiden Lichtintensitaten I1 und I2 als Meßsignal M herangezogen. Dieser Quotient gemäß Gleichung (13) oder (13') ergibt sich aus dem allgemeinen Quotienten gemäß Gleichung (11), wenn man die Koeffizienten a=e=1 und b=c=d=f=0 bzw. a=c=e=f=0 und b=d=1 wählt. Dieses Meßsignal M hängt in vergleichsweise komplizierter, jedoch eindeutiger Weise von dem Meßwinkel ρ und damit vom Magnetfeld **H** ab.

Insbesondere bei wenigstens annähernd gleichen Eingangsintensitäten I1. und I2' beider Lichtsignale L1' und L2' kann in einer vorteilhaften Ausführungsform als Meßsignal M auch der Quotient

$$M = (I1-I2)/(I1+I2) \qquad (14)$$

aus einer Differenz I1-I2 (oder I2-I1) und der Summe I1+I2 beider Lichtintensitäten I1 und I2 nach Durchlaufen der Reihenschaltung verwendet werden. Dieses Meßsignal M ist dann wieder proportional zu sin(2ρ), wenn keine linearen Doppelbrechungseffekte in der Sensoreinrichtung 3 auftreten.

Das von den Dampfungsfaktoren A und B der Übertragungsstrecken 4 und 7 befreite Meßsignal M kann von den Auswertemitteln 20 auf verschiedene Arten aus den beiden Lichtintensitäten I1 und I2 der beiden gegenläufigen Lichtsignale L1 und L2 abgeleitet werden. Im allgemeinen werden beide Lichtsignale L1 und L2 von den Auswertemitteln 20 zunächst photoelektrisch in jeweils ein elektrisches Intensitätssignal umgewandelt, das ein direktes Maß für die Lichtintensität I1 bzw. I2 des jeweiligen Lichtsignals L1 bzw. L2 ist. Aus diesen beiden elektrischen Intensitätssignalen wird das Meßsignal M mit Hilfe einer Wertetabelle oder auch rechnerisch bestimmt. Die Auswertemittel 20 enthalten dazu entsprechende analoge oder digitale Bausteine.

In einer nicht dargestellten Ausführungsform werden die beiden elektrischen Intensitätssignale zunächst mit Hilfe eines Analog/Digital-Wandlers digitalisiert und die digitalisierten Signale werden von einem Mikroprozessor oder einem digitalen Signalprozessor gemäß einer der Gleichungen (11), (13), (13') oder (14) weiterverarbeitet.

Insbesondere zum rechnerischen Ermitteln des Meßsignals M als vorgegebene Funktion M(I1,I2) der beiden Lichtintensitäten I1 und I2 gemäß Gleichung (11), (13), (13') oder (14) können auch analoge Komponenten verwendet werden, die in der Regel schneller arbeiten als digitale Komponenten.

In der Ausführungsform gemäß FIG. 2 enthält die Meßanordnung Auswertemittel 20 mit analogen Bausteinen. Die Auswertemittel 20 umfassen in dieser Ausführungsform zwei photoelektrische Wandler 21 und 22, einen Subtrahierer 23, einen Addierer 24 und einen Dividierer 25. Der erste Wandler 21 ist optisch mit dem Koppler 13 verbunden und wandelt das erste Lichtsignal L1 nach dessen Durchlaufen der Reihenschaltung in ein erstes elektrisches Intensitätssignal S1 um, dessen Signalstärke der Lichtintensität I1 des ersten Lichtsignals L1 entspricht. Der zweite Wandler 22 ist mit dem Koppler 12 optisch verbunden und konvertiert das zweite Lichtsignal L2 nach dessen Durchlauf durch die Reihenschaltung in ein zweites elektrisches Intensitätssignal S2 als Maß für die Lichtintensität I2 des zweiten Lichtsignals L2. Beide elektrischen Intensitätssignale S1 und S2 werden jeweils einem Eingang des Subtrahierers 23 und des Addierers 24 zugeführt. Das Differenzsignal S1-S2 (oder S2-S1) am Ausgang des Subtrahierers 23 und das Summensignal S1+S2 am Ausgang des Addierers 24 werden jeweils einem Eingang des Dividierers 25 zugeführt. Das Ausgangssignal des Dividierers (S1-S2)/(S1+S2) wird als Meßsignal M herangezogen und auf einen Ausgang der Auswertemittel 20 geschaltet. Dieses Meßsignal M entspricht also der Gleichung (14).

Ein der allgemeineren Gleichung (11) genügendes Meßsignal M kann man mit Hilfe analoger Komponenten in einer nicht dargestellten Ausführungsform einfach dadurch erhalten, daß man vor die Eingänge von Subtrahierer 23 und Addierer 24 jeweils zusätzlich einen Verstärker schaltet und die Verstärkungsfaktoren dieser Verstärker den entsprechenden Koeffizienten a, -b für negatives b, d und e der beiden linearen Funktionen in Gleichung (4) anpaßt sowie weitere Addierer zum Hinzuaddieren des Koeffizienten c zu dem Ausgangssignal des Subtrahierers 23 gemäß dem Zähler in Gleichung (11) und des Koeffizienten f zu dem Ausgangssignal am Ausgang des Addierers 24 gemäß dem Nenner in Gleichung (11) vorsieht. Die Ausgangssignale der beiden weiteren Addierer werden dann den Eingängen des Dividierers 25 zugeführt. Ist b positiv, so wird anstelle des Subtrahierers 23 vorzugsweise ein weiterer Addierer eingesetzt.

Durch Anpassen der Koeffizienten a, b, c, d, e und f beim gemäß Gleichung (11) gebildeten Meßsignal M können in einer besonderen Ausführungsform auch unterschiedliche Empfindlichkeiten der beiden photoelektrischen Wandler 21 und 22 ausgeglichen werden.

Der vorgegebene Drehwinkel α der Rotationsmittel 8 wird in allen Ausführungsformen vorzugsweise auf ein ungeradzahliges Vielfaches von etwa ± 45° oder etwa ± π/4 eingestellt. Es können jedoch auch andere Drehwinkel α verwendet werden.

Ein zusätzliches Problem bei der Messung eines Magnetfeldes **H** oder eines elektrischen Stromes I gemäß einem der beschriebenen Meßverfahren oder einer der beschriebenen Meßanordnungen können Temperatureinflüsse in der Sensoreinrichtung 3 darstellen. Diese Temperatureinflüsse induzieren eine lineare Doppelbrechung δ als Funktion δ(T) der Temperatur T in der Sensoreinrichtung 3, die die Messung des Magnetfeldes **H** oder des elektrischen Stromes I verfälschen kann. Ferner können Temperaturänderungen auch die Verdet-Konstante und damit die Meßempfindlichkeit verändern.

Diese Temperaturabhängigkeit des Meßsignals M wird nun durch die im folgenden beschriebenen Maßnahmen zur Temperaturkompensation im wesentlichen beseitigt. Die Polarisationsachsen P1 und P2 der beiden Polarisatoren 5 und 6 werden unter einem in FIG 4 dargestellten Polarisatorwinkel γ zu einer Eigenachse (Hauptachse, optische Achse) EA der linearen Doppelbrechung δ in der Sensoreinrichtung 3. eingestellt. Der Polarisatorwinkel γ ist wenigstens annähernd gemäß der Gleichung

$$\cos(4\gamma - 2\alpha) = -2/3 \qquad (15)$$

bestimmt. Eine Eigenachse EA der linearen Doppelbrechung δ ist dabei durch diejenige Polarisationsrichtung definiert, unter der in die Sensoreinrichtung 3 eingekoppeltes linear polarisiertes Licht die Sensoreinrichtung 3 unverändert wieder verläßt. Wird linear polarisiertes Licht dagegen mit einer nicht parallel zu einer der Eigenachsen der Sensoreinrichtung 3 gerichteten Polarisationsebene in die Sensoreinrichtung 3 eingekoppelt, so wird das Licht beim Durchlaufen der Sensoreinrichtung 3 aufgrund der linearen Doppelbrechung δ elliptisch polarisiert. Die im allgemeinen zueinander orthogonalen beiden Eigenachsen der linearen Doppelbrechung δ können in an sich bekannter Weise bestimmt werden. Beispielsweise kann die Sensoreinrichtung 3 zwischen einem Polarisator, beispielsweise dem Polarisator 5, und einem Analysator, beispielsweise dem Polarisator 6, angeordnet werden. Die Polarisationsachsen der beiden Polarisatoren werden senkrecht zueinander eingestellt. Nun werden in einer Ausführungsform die beiden Polarisationsachsen von Polarisator und Analysator gleichsinnig gegen eine Bezugsachse der Sensoreinrichtung 3 gedreht, bis die Intensität des vom Analysator transmittierten Lichts gleich Null ist (maximale Lichtauslöschung). Die Eigenachsen sind dann parallel zu den beiden Polarisationsachsen von Polarisator und Analysator. Alternativ dazu können in einer anderen Ausführungsform die beiden Polarisationsachsen auch gleichsinnig gegen die Bezugsachse der Sensoreinrichtung 3 gedreht werden, bis die Intensität des vom Analysator transmittierten Lichts maximal ist (minimale Lichtauslöschung). In diesem Fall ist das Licht beim Austreten aus der Sensoreinrichtung 3 zirkular polarisiert. Die Eigenachsen der linearen Doppelbrechung $\delta$ liegen dann um 45° bzw. -45° versetzt zur Polarisationsachse des Analysators.

Wählt man den bevorzugten Drehwinkel $\alpha$ = - 45° oder $\alpha$ = - 45° - n · 180° = - (1+4n) · 45° mit der beliebigen ganzen Zahl n, so reduziert sich die Gleichung (15) auf

$$\sin(4\gamma) = + 2/3 \qquad (15').$$

Bei dem Drehwinkel $\alpha$ = + 45° oder $\alpha$ = + (1+4n) · 45° mit der beliebigen ganzen Zahl n reduziert sich die Gleichung (15) dagegen auf

$$\sin(4\gamma) = - 2/3 \qquad (15'').$$

Ein möglicher, die Gleichung (15') erfüllender Wert für den Polarisatorwinkel $\gamma$ ist beispielsweise $\gamma$ = + 10,45°. Ein Polarisatorwinkel $\gamma$, der Gleichung (15'') erfüllt, ist beispielsweise $\gamma$ = - 10,450.

Abweichungen von den die Gleichung (15), (15') oder (15'') exakt erfüllenden Winkelwerten für den Polarisatorwinkel $\gamma$ sind möglich, insbesondere bei inhomogener linearer und/oder zirkularer Doppelbrechung und/oder einer stark temperaturabhängigen Verdet-Konstanten in der Sensoreinrichtung 3, und können im allgemeinen bis zu etwa 5° betragen. Auch der Drehwinkel $\alpha$ kann bis zu etwa ± 10° von seinem Idealwert $\alpha$ = + (1+4n) · 45° oder $\alpha$ = - (1+4n) · 45° für die Temperaturkompensation abweichen.

Das mit einem wenigstens annähernd gemäß Gleichung (15), (15') oder (15'') eingestellten Polarisatorwinkel $\gamma$ ermittelte Meßsignal M entspricht nun auch bei sich ändernden Temperaturen in der Sensoreinrichtung 3 im wesentlichen dem Meßsignal ohne lineare Doppelbrechung $\delta$, im Falle eines gemäß Gleichung (11) oder (14) hergeleiteten Meßsignals M also einer zu sin(2$\rho$) proportionalen Größe gemäß der Beziehung (12).

Der gemäß Gleichung (15), (15') oder (15'') optimale Polarisatorwinkel $\gamma$ der beiden Polarisatoren 5 bzw. 6 zur Eigenachse der linearen Doppelbrechung $\delta$ kann in einer besonderen Ausführungsform einfach so eingestellt werden, daß man in einer Eichmessung das Meßsignal M in seiner Abhängigkeit von der Temperatur mit seinem zu erwartenden Sollwert ohne lineare Doppelbrechung $\delta$, insbesondere gemäß der Beziehung (12), für einen vorgegebenen Polarisatorwinkel $\gamma$ als Parameter vergleicht und den Polarisatorwinkel $\gamma$ so lange verändert, bis das aktuelle Meßsignal M mit dem praktisch temperaturunabhängigen Sollwert übereinstimmt.

Ein Vorteil der Temperaturkompensation durch Einstellen des Polarisatorwinkels $\gamma$ ist die hohe Bandbreite beim Messen von Magnetfeldern **H** oder elektrische Strömen I. Das Frequenzspektrum der zu messenden Magnetfelder **H** oder elektrischen Ströme I wird durch die Maßnahmen zur Temperaturkompensation nämlich prinzipiell nicht beschränkt.

**Patentansprüche**

1. Verfahren zum Messen eines Magnetfeldes (**H**) mit einer den Faraday-Effekt zeigenden Sensoreinrichtung (3), bei dem

   a) zwei Lichtsignale (L1,L2) eine optische Reihenschaltung aus einer ersten optischen Übertragungsstrecke (4), einem ersten Polarisator (5), der Sensoreinrichtung (3), einem zweiten Polarisator (6) und einer zweiten optischen Übertragungsstrecke (7) in zueinander entgegengesetzten Richtungen durchlaufen,
   b) zwischen den beiden Polarisatoren (5,6) die Polarisationsebenen beider Lichtsignale (L1,L2) um einen vom Magnetfeld (**H**) unabhängigen, vorgegebenen Drehwinkel $\alpha$ gedreht werden und
   c) aus den Lichtintensitäten (I1,I2) der beiden Lichtsignale (L1,L2) jeweils nach deren Durchlaufen der optischen Reihenschaltung ein von Intensitätsänderungen in den beiden Übertragungsstrecken (4,7) im wesentlichen unabhängiges Meßsignal (M) für das Magnetfeld (**H**) ermittelt wird.

2. Verfahren nach Anspruch 1, bei dem die Polarisationsachsen (P1,P2) der beiden Polarisatoren (5,6) parallel oder orthogonal zueinander eingestellt werden.

3. Verfahren nach Anspruch 1 oder Anspruch 2, bei dem das Meßsignal (M) einem Quotienten ((a·I1+b·I2+c)/(d·I1+e·I2+f)) zweier linearer Funktionen der Lichtintensitäten (I1,I2) der beiden Lichtsignale (L1,L2) entspricht.

4. Verfahren nach Anspruch 3, bei dem das Meßsignal (M) proportional zum Quotienten ((I1-I2)/(I1+I2)) aus einer Differenz und der Summe der beiden Lichtintensitäten (I1,I2) ist.

5. Verfahren nach Anspruch 3, bei dem das Meßsignal (M) proportional zu einem Quotienten (I1/I2 oder I2/I1) der beiden Lichtintensitäten (I1,I2) ist.

**6.** Verfahren nach einem der vorhergehenden Ansprüche, bei dem die Polarisationsebenen der beiden Lichtsignale (L1,L2) zwischen den Polarisatoren (5,6) jeweils um einen Drehwinkel $\alpha$ gedreht werden, der einem ungeradzahligen Vielfachen von + 45° oder - 45° entspricht.

**7.** Verfahren nach Anspruch 6, bei dem die Polarisationsachsen (P1,P2) der beiden Polarisatoren (5,6) um einen Polarisatorwinkel $\gamma$ gegen eine Eigenachse (EA) der linearen Doppelbrechung in der Sensoreinrichtung (3) gedreht eingestellt werden, wobei der Polarisatorwinkel $\gamma$ die Beziehung

$$\sin(4\gamma) = + 2/3$$

für Drehwinkel $\alpha$, die einem Winkel $- (1+4n) \cdot 45°$ entsprechen, oder

$$\sin(4\gamma) = - 2/3$$

für Drehwinkel $\alpha$, die einem Winkel $+ (1+4n) \cdot 45°$ entsprechen, mit einer ganzen Zahl n erfüllt.

**8.** Verfahren nach einem der vorhergehenden Ansprüche, bei dem das Magnetfeld (**H**) eines elektrischen Stromes (I) gemessen wird und das Meßsignal (M) als Maß für den elektrischen Strom (I) herangezogen wird.

**9.** Anordnung zum Messen eines Magnetfeldes (**H**) mit

a) einer optischen Reihenschaltung aus einer ersten optischen Übertragungsstrecke (4), einem ersten Polarisator (5), einer den Faraday-Effekt zeigenden Sensoreinrichtung (3), einem zweiten Polarisator (6) und einer zweiten optischen Übertragungsstrecke (7),
b) Mitteln (10, 11, 12,13) zum Senden von zwei Lichtsignalen (L1,L2) durch die optische Reihenschaltung, die die Reihenschaltung gegensinnig durchlaufen,
c) Auswertemitteln (20) zum Ableiten eines von Intensitätsänderungen in den beiden Übertragungsstrecken (4,7) im wesentlichen unabhängigen Meßsignals (M) für das Magnetfeld (**H**) aus den Lichtintensitäten (I1,I2) der beiden Lichtsignale (L1,L2) nach deren Durchlaufen der optischen Reihenschaltung und mit
d) optisch zwischen die beiden Polarisatoren (5,6) geschalteten optischen Rotationsmitteln (8) zum Drehen der Polarisationsebenen beider Lichtsignale (L1,L2) um einen vom Magnetfeld (**H**) unabhängigen, vorgegebenen Drehwinkel $\alpha$.

**10.** Anordnung nach Anspruch 9, bei der die Polarisationsachsen (P1,P2) der beiden Polarisatoren (5,6) parallel oder orthogonal zueinander eingestellt sind.

**11.** Anordnung nach Anspruch 9 oder 10, bei der die Rotationsmittel wenigstens ein Rotationselement (8,8A,8B) umfassen, das eine reziproke zirkuläre Doppelbrechung aufweist.

**12.** Anordnung nach Anspruch 11, bei der das wenigstens eine Rotationselement (8,8A,8B) optische Aktivität aufweist.

**13.** Anordnung nach Anspruch 11, bei der die reziproke zirkulare Doppelbrechung des wenigstens einen Rotationselements (8') geometrisch induziert ist.

**14.** Anordnung nach einem der Ansprüche 9 bis 13, bei der die Sensoreinrichtung (3) selbst wenigstens einen Teil der Rotationsmittel bildet.

**15.** Anordnung nach einem der Ansprüche 9 bis 14, bei der die Auswertemittel (20) ein Meßsignal (M) ableiten, das einem Quotienten $((a \cdot I1+b \cdot I2+c)/(d \cdot I1+e \cdot I2+f))$ zweier linearer Funktionen der Lichtintensitäten (I1,I2) der beiden Lichtsignale (L1,L2) jeweils nach deren Durchlaufen der optischen Reihenschaltung entspricht.

**16.** Anordnung nach Anspruch 15, bei der die Auswertemittel (20) ein Meßsignal (M) ableiten, das proportional zum Quotienten $((I1-I2)/(I1+I2))$ aus einer Differenz und der Summe der beiden Lichtintensitäten (I1,I2) ist.

**17.** Anordnung nach Anspruch 15, bei der die Auswertemittel (20) ein Meßsignal (M) ableiten, das proportional zu einem Quotienten (I1/I2 oder I2/I1) der beiden Lichtintensitäten (I1,I2) ist.

**18.** Anordnung nach einem der Ansprüche 9 bis 17, bei der die beiden optischen Übertragungsstrecken (4,7) mit Multimode-Lichtleitern gebildet sind.

**19.** Anordnung nach einem der Ansprüche 9 bis 18, bei der die Rotationsmittel (8) die Polarisationsebenen der beiden Lichtsignale (L1,L2) jeweils um einen Drehwinkel $\alpha$ drehen, der betragsmäßig einem ungeradzahligen Vielfachen von 45° entspricht.

**20.** Anordnung nach einem der Ansprüche 9 bis 19, bei der die Polarisationsachsen (P1,P2) der beiden Polarisatoren (5,6) um einen Polarisatorwinkel $\gamma$ gegen eine Eigenachse (EA) der linearen Doppelbrechung in der Sensoreinrichtung (3) gedreht sind und dieser Polarisatorwinkel γ die Beziehung

$$\sin(4\gamma) = +2/3$$

für Drehwinkel α, die einem Winkel - (1+4n) · 45° entsprechen, oder

$$\sin(4\gamma) = -2/3$$

für Drehwinkel α, die einem Winkel + (1+4n) · 45° entsprechen, mit einer ganzen Zahl n erfüllt.

21. Anordnung nach einem der Ansprüche 9 bis 20, bei der die Sensoreinrichtung (3) im Magnetfeld (**H**) eines elektrischen Stromes (I) angeordnet ist und die Auswertemittel (20) das Meßsignal (M) als Maß für den elektrischen Strom (I) ableiten.

## Claims

1. Method for measuring a magnetic field (H) with a sensor device (3) exhibiting the Faraday effect, in which method

    a) two light signals (L1,L2) pass through an optical series circuit consisting of a first optical transmission path (4), a first polarizer (5), the sensor device (3), a second polarizer (6) and a second optical transmission path (7) in mutually opposite directions,
    b) between the two polarizers (5,6), the planes of polarization of both the light signals (L1,L2) are rotated by a predetermined angle of rotation α which is independent of the magnetic field (H) and
    c) from the light intensities (I1,I2) of the two light signals (L1,L2), in each case after their passage through the optical series circuit, a measured signal (M) which is essentially independent of intensity changes in the two transmission paths (4, 7) is determined for the magnetic field (H).

2. Method according to Claim 1, in which the axes of polarization (P1,P2) of the two polarizers (5,6) are set parallel or orthogonal to each other.

3. Method according to Claim 1 or Claim 2, in which the measured signal (M) corresponds to a quotient ((a×I1+b×I2+c)/(d×I1+e×I2+f)) of two linear functions of the light intensities (I1,I2) of the two light signals (L1,L2).

4. Method according to Claim 3, in which the measured signal (M) is proportional to the quotient ((I1-I2)/(I1+I2)) of a difference and the sum of the two light intensities (I1,I2).

5. Method according to Claim 3, in which the measured signal (M) is proportional to a quotient (I1/I2 or I2/I1) of the two light intensities (I1,I2).

6. Method according to one of the preceding claims, in which the planes of polarization of the two light signals (L1,L2) are rotated between the polarizers (5,6) in each case by an angle of rotation α which corresponds to an odd multiple of + 45° or - 45°.

7. Method according to Claim 6, in which the axes of polarization (P1,P2) of the two polarizers (5,6) are set rotated by a polarizer angle γ in relation to an intrinsic axis (EA) of the linear birefringence in the sensor device (3), the polarizer angle γ fulfilling the relationship

$$\sin(4\gamma) = +2/3$$

for angles of rotation α which correspond to an angle - (1+4n) × 45°, or

$$\sin(4\gamma) = -2/3$$

for angles of rotation α which correspond to an angle + (1+4n) × 45°, with a whole number n.

8. Method according to one of the preceding claims, in which the magnetic field (H) of an electric current (I) is measured and the measured signal (M) is used as a measure of the electric current (I).

9. Arrangement for measuring a magnetic field (H) having

    a) an optical series circuit consisting of a first optical transmission path (4), a first polarizer (5), a sensor device (3) exhibiting the Faraday effect, a second polarizer (6) and a second optical transmission path (7),
    b) means (10,11,12,13) for transmitting two light signals (L1,L2) through the optical series circuit, the signals passing through the series circuit in opposite directions,
    c) evaluation means (20) for deriving a measured signal (M), which is essentially independent of intensity changes in the two transmission paths (4,7), for the magnetic field (H) from the light intensities (I1,I2) of the two light signals (L1,L2) after their passage through the optical series circuit and having
d) optical rotation means (8), optically connected between the two polarizers (5,6), for rotating the planes of polarization of both the light signals (L1,L2) by a predetermined angle of rotation $\alpha$ which is independent of the magnetic field (H).

10. Arrangement according to Claim 9, in which the axes of polarization (P1,P2) of the two polarizers (5,6) are set parallel or orthogonal to each other.

11. Arrangement according to Claim 9 or 10, in which the rotation means comprise at least one rotation element (8,8A,8B) which exhibits a reciprocal circular birefringence.

12. Arrangement according to Claim 11, in which the at least one rotation element (8,8A,8B) exhibits optical activity.

13. Arrangement according to Claim 11, in which the reciprocal circular birefringence of the at least one rotation element (8') is geometrically induced.

14. Arrangement according to one of Claims 9 to 13, in which the sensor device (3) itself forms at least part of the rotation means.

15. Arrangement according to one of Claims 9 to 14, in which the evaluation means (20) derive a measured signal (M) which corresponds to a quotient $((a \times I1 + b \times I2 + c)/(d \times I1 + e \times I2 + f))$ of two linear functions of the light intensities (I1,I2) of the two light signals (L1,L2), in each case after their passage through the optical series circuit.

16. Arrangement according to Claim 15, in which the evaluation means (20) derive a measured signal (M) which is proportional to the quotient $((I1-I2)/(I1+I2))$ of a difference and the sum of the two light intensities (I1,I2).

17. Arrangement according to Claim 15, in which the evaluation means (20) derive a measured signal (M) which is proportional to a quotient (I1/I2 or I2/I1) of the two light intensities (I1,I2).

18. Arrangement according to one of Claims 9 to 17, in which the two optical transmission paths (4,7) are formed with multimode optical fibres.

19. Arrangement according to one of Claims 9 to 18, in which the rotation means (8) rotate the planes of polarization of the two light signals (L1,L2) in each case by an angle of rotation $\alpha$ which corresponds in terms of magnitude to an odd multiple of 45°.

20. Arrangement according to one of Claims 9 to 19, in which the axes of polarization (P1,P2) of the two polarizers (5,6) are rotated by a polarizer angle $\gamma$ in relation to an intrinsic axis (EA) of the linear birefringence in the sensor device (3) and this polarizer angle $\gamma$ fulfils the relationship

$$\sin(4\gamma) = + 2/3$$

for angles of rotation $\alpha$ which correspond to an angle $- (1+4n) \times 45°$, or

$$\sin(4\gamma) = - 2/3$$

for angles of rotation $\alpha$ which correspond to an angle $+ (1+4n) \times 45°$,
with a whole number n.

21. Arrangement according to one of Claims 9 to 20, in which the sensor device (3) is arranged in the magnetic field (H) of an electric current (I), and the evaluation means (20) derive the measured signal (M) as a measure of the electric current (I).

**Revendications**

1. Procédé pour mesurer un champ magnétique (H) avec un dispositif capteur (3) montrant l'effet Faraday, dans lequel

a) deux signaux lumineux (L1, L2) passent en sens contraire dans un circuit série optique formé d'une première voie de transmission optique (4), d'un premier polarisateur (5), du dispositif capteur (3), d'un deuxième polarisateur (6) et d'une deuxième voie de transmission optique (7),
b) entre les deux polarisateurs (5, 6), les plans de polarisation des deux signaux lumineux (L1, L2) sont tournés d'un angle de rotation $\alpha$ prescrit, indépendant du champ magnétique (H), et
c) à partir des intensités lumineuses (I1, I2) des deux signaux lumineux (L1, L2) après leur passage dans leur circuit série optique, on détermine un signal de mesure (M) du champ magnétique (H) sensiblement indépendant de variations d'intensité dans les deux voies de transmission (4, 7).

2. Procédé selon la revendication 1, dans lequel les axes de polarisation (P1, P2) des deux polarisateurs (5, 6) sont réglés parallèles ou orthogonaux l'un à l'autre.

3. Procédé selon la revendication 1 ou 2, dans lequel le signal de mesure (M) correspond à un quotient $((a \cdot I1 + b \cdot I2 + c) / (d \cdot I1 + e \cdot I2 + f))$ de deux fonctions linéaires des intensités lumineuses (I1, I2) des deux signaux lumineux (L1, L2).

4. Procédé selon la revendication 3, dans lequel le signal de mesure (M) est proportionnel au quotient $((I1 - I2) / (I1 + I2))$ d'une différence et de la somme des deux intensités lumineuses (I1, I2).

5. Procédé selon la revendication 3, dans lequel le signal de mesure (M) est proportionnel à un quotient (I1/I2 ou I2/I1) des deux intensités lumineuses (I1, I2).

6. Procédé selon l'une des revendications précédentes, dans lequel les plans de polarisation des deux signaux lumineux (L1, L2) entre les polarisateurs (5, 6) sont tournés respectivement d'un angle de rotation α qui correspond à un multiple impair de + 45° ou de - 45°.

7. Procédé selon la revendication 6, dans lequel les axes de polarisation (P1, P2) des deux polarisateurs (5, 6) sont tournés d'un angle de polarisateurs γ par rapport à un axe propre (EA) de la double réfraction linéaire dans le dispositif capteur (3), l'angle de polarisateurs γ satisfaisant à la relation

$$\sin (4\gamma) = + 2/3$$

pour des angles de rotation α qui correspondent à un angle
$-(1 + 4n) \cdot 45°$, ou

$$\sin (4\gamma) = - 2/3$$

pour des angles de rotation α qui correspondent à un angle
$+(1 + 4n) \cdot 45°$,
avec un nombre entier n.

8. Procédé selon l'une des revendications précédentes, dans lequel on mesure le champ magnétique (H) d'un courant électrique (I) et on exploite le signal de mesure (M) comme mesure du courant électrique (I).

9. Dispositif pour mesurer un champ magnétique (H), comportant

   a) un circuit série optique formé d'une première voie de transmission optique (4), d'un premier polarisateur (5), d'un dispositif capteur (3) montrant l'effet Faraday, d'un deuxième polarisateur (6) et d'une deuxième voie de transmission optique (7),

   b) des moyens (10, 11, 12, 13) pour envoyer deux signaux lumineux (L1, L2) dans le circuit série optique, lesquels signaux lumineux passent en sens contraire dans le circuit série,

   c) des moyens de traitement (20) pour déduire un signal de mesure (M), du champ magnétique (H) sensiblement indépendant de variations d'intensité dans les deux voies de transmission (4, 7), à partir des intensités lumineuses (I1, I2) des deux signaux lumineux (L1, L2) après leur passage dans le circuit série optique, et

   d) des moyens de rotation (8) optiques qui sont branchés optiquement entre les deux polarisateurs (5, 6) et qui sont destinés à tourner les plans de polarisation des deux signaux lumineux (L1, L2) d'un angle de rotation α prescrit, indépendant du champ magnétique (H).

10. Dispositif selon la revendication 9, dans lequel les axes de polarisation (P1, P2) des deux polarisateurs (5, 6) sont réglés parallèles ou orthogonaux l'un à l'autre.

11. Dispositif selon la revendication 9 ou 10, dans lequel les moyens de rotation comprennent au moins un élément de rotation (8, 8A, 8B) qui présente une double réfraction circulaire réciproque.

12. Dispositif selon la revendication 11, dans lequel l'élément de rotation (8, 8A, 8B) - il y en a au moins un - présente une action optique.

13. Dispositif selon la revendication 11, dans lequel la double réfraction circulaire réciproque de l'élément de rotation (8') - il y en a au moins un - est induite géométriquement.

14. Dispositif selon l'une des revendications 9 à 13, dans lequel le dispositif capteur (3) lui-même constitue au moins une partie des moyens de rotation.

15. Dispositif selon l'une des revendications 9 à 14, dans lequel les moyens de traitement (20) déduisent un signal de mesure (M) qui correspond à un quotient $((a \cdot I1 + b \cdot I2 + c) / (d \cdot I1 + e \cdot I2 + f))$ de deux fonctions linéaires des intensités lumineuses (I1, I2) des deux signaux lumineux (L1, L2) après leur passage dans le circuit série optique.

16. Dispositif selon la revendication 15, dans lequel les moyens de traitement (20) déduisent un signal de mesure (M), qui est proportionnel au quotient $((I1 - I2) / (I1 + I2))$ d'une différence et de la somme des deux intensités lumineuses (I1, I2).

17. Dispositif selon la revendication 15, dans lequel les moyens de traitement (20) déduisent un signal de mesure (M), qui est proportionnel à un quotient (I1/I2 ou I2/I1) des deux intensités lumineuses (I1, I2).

18. Dispositif selon l'une des revendications 9 à 17, dans lequel les deux voies de transmission optiques (4, 7) sont formées de fibres optiques multimodales.

19. Dispositif selon l'une des revendications 9 à 18, dans lequel les moyens de rotation (8) tournent les plans de polarisation des deux signaux lumineux (L1, L2) respectivement d'un angle de rotation $\alpha$ dont la valeur absolue correspond à un multiple impair de 45°.

20. Dispositif selon l'une des revendications 9 à 19, dans lequel les axes de polarisation (P1, P2) des deux polarisateurs (5, 6) sont tournés d'un angle de polarisateurs $\gamma$ par rapport à un axe propre (EA) de la double réfraction linéaire dans le dispositif capteur (3) et cet angle de polarisateurs $\gamma$ satisfait à la relation

$$\sin(4\gamma) = + 2/3$$

pour des angles de rotation $\alpha$ qui correspondent à un angle
$-(1 + 4n) \cdot 45°$, ou

$$\sin(4\gamma) = - 2/3$$

pour des angles de rotation $\alpha$ qui correspondent à un angle
$+(1 + 4n) \cdot 45°$,
avec un nombre entier n.

21. Dispositif selon l'une des revendications 9 à 20, dans lequel le dispositif capteur (3) est agencé dans le champ magnétique (H) d'un courant électrique (I) et les moyens de traitement (20) déduisent le signal de mesure (M) comme mesure du courant électrique (I).

FIG 1

FIG 2

FIG 3

FIG 4